# FASCICULE DE BREVET EUROPEEN

(11) **EP 2 167 985 B1**
(45) Date de publication et mention de la délivrance du brevet: **07.09.2011**
(21) Numéro de dépôt: 08774782.0
(22) Date de dépôt: 04.07.2008
(51) Int. Cl.: G01R 33/09

(54) **CAPTEUR DE CHAMP MAGNÉTIQUE À FAIBLE BRUIT UTILISANT UN TRANSFERT DE SPIN LATERAL**
LATERALEN SPIN-TRANSFER VERWENDENDER RAUSCHARMER MAGNETFELDSENSOR
LOW-NOISE MAGNETIC FIELD SENSOR USING LATERAL SPIN TRANSFER

(30) Priorité: 10.07.2007 FR 0756395
(43) Date de publication de la demande: 31.03.2010
(73) Titulaire: Commissariat à l'Énergie Atomique et aux Énergies Alternatives, 75015 Paris (FR); Centre National de la Recherche Scientifique, 75016 Paris (FR)
(72) Inventeur: DIENY, Bernard, F-38250 Lans En Vercors (FR)
(74) Mandataire: Ilgart, Jean-Christophe
(86) Numéro de dépôt international: PCT/EP2008/058704
(87) Numéro de publication internationale: WO 2009/007324

(56) Documents cités:
- US-A1- 2005 041 342
- US-A1- 2005 280 958
- US-A1- 2006 050 446
- POLIANSKI M L ET AL: "Current-induced transverse spin-wave instability in a thin nanomagnet" PHYSICAL REVIEW LETTERS APS USA, vol. 92, no. 2, 16 janvier 2004 (2004-01-16), pages 026602/1-4, XP002483059 ISSN: 0031-9007

## Description

### DOMAINE TECHNIQUE

La présente invention concerne le domaine des capteurs de champ magnétique et plus particulièrement celui des vannes de spin à géométrie de courant perpendiculaire au plan des couches.

Elle trouve notamment application dans le domaine de l'enregistrement magnétique.

### ÉTAT DE LA TECHNIQUE ANTÉRIEURE

Les capteurs de champ magnétique sont utilisés dans de nombreuses applications, têtes de lecture de disques durs d'ordinateurs, dispositifs de lecture de pistes magnétiques, d'encre magnétique, codeurs de position, codeurs angulaires, compas électroniques, etc.

Les capteurs de champ magnétique ont fait l'objet de recherches considérables ces dernières années afin de suivre l'augmentation rapide de la densité d'enregistrement sur les disques durs.

Depuis 1992, les capteurs de champ magnétique utilisés dans les têtes de lecture de disques durs d'ordinateurs sont de type magnétorésistif. Dans un capteur de ce type, les variations de champ magnétique modifient la résistance d'un matériau magnétorésistif, ce qui se traduit par des variations de tension aux bornes du capteur.

Les premiers capteurs magnétorésistifs exploitaient l'anisotropie de la magnétorésistance d'une couche mince magnétique, c'est-à-dire la dépendance de la résistance d'une telle couche en fonction de l'angle entre l'aimantation et le courant qui lui était appliqué.

Les capteurs magnétorésistifs plus récents sont basés sur des vannes de spin. Une vanne de spin est généralement définie comme une structure constituée de deux couches magnétiques séparées par une fine couche de métal non magnétique. L'aimantation d'une des couches magnétiques, dite couche piégée, est maintenue fixe par interaction d'échange avec un matériau antiferromagnétique. L'aimantation de l'autre couche magnétique, dite couche libre ou sensible, est libre de suivre les variations du champ magnétique qui lui est appliqué. La variation d'orientation relative des aimantations respectives des deux couches magnétiques induit un changement de résistance électrique au sein de la couche non magnétique (effet dit de magnétorésistance géante). On trouvera une description des vannes de spin par exemple dans l'article de B. Dieny intitulé « Giant magnetoresistance in spin-valve multilayers », publié dans Journ. Magn. Mater. 136, (1994), pp. 335-359 ou dans US2006050446, US2005280958 ou US2005041342.

Les premières vannes de spin utilisaient une géométrie de courant parallèle au plan des couches selon une configuration dite CIP (*Current In Plane*). La réduction de la taille des bits sur les disques durs (environ 100nm x 40nm en 2006) a conduit à développer des vannes de spin à configuration CPP (*Current Perpendicular to Plane*) présentant à la fois un plus haut niveau d'intégration et une plus forte variation de magnétorésistance.

Selon cette configuration, les écrans qui encadrent l'élément magnétorésistif servent également à l'amenée du courant et la prise de tension. On trouvera notamment une description d'une vanne de spin à configuration CPP dans la demande WO-A-97/44781.

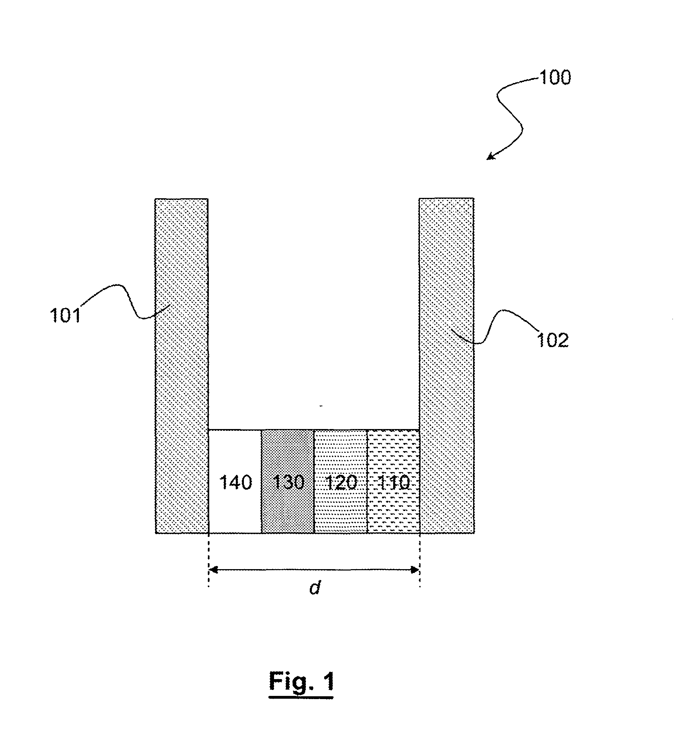

La Fig. 1 illustre schématiquement un capteur magnétorésistif utilisant une vanne de spin 100 à configuration CPP.

Les deux écrans métalliques 101 et 102 servent à délimiter la zone de mesure du champ magnétique ainsi qu'à l'amenée de courant et la prise de tension. La largeur d de cette zone donne la résolution maximale de lecture. La vanne de spin est essentiellement constituée d'une couche antiferromagnétique 110, d'une couche magnétique 120 dont l'aimantation est piégée par la couche 110, d'une couche mince non magnétique 130, et d'une couche magnétique 140 dont l'aimantation est libre de suivre le champ magnétique extérieur. Un champ magnétique de biais (*bias magnetic field*) peut être appliqué à la couche libre 140 au moyen d'un couple d'aimants permanents latéraux (non représentés) de sorte à lui donner une orientation d'aimantation prédéterminée, en l'absence de champ magnétique extérieur.

La résistance de la vanne de spin est faible si les directions des aimantations de la couche libre 140 et de la couche piégée 120 sont parallèles, et élevée dans le cas où elles sont antiparallèles. Lorsqu'un champ magnétique à mesurer est appliqué dans le plan des couches, ce champ produit une rotation de l'aimantation de la couche libre dans ledit plan. L'orientation relative de l'aimantation de la couche libre par rapport à celle de la couche piégée détermine la résistance de la vanne de spin.

Les vannes de spin à configuration CPP présentent une très faible résistance, du fait de la faible épaisseur des couches qui les constituent et de leur caractère métallique. Afin de réaliser des capteurs d'impédance adaptée à l'impédance d'entrée typique d'un préamplificateur (∼ quelques dizaines d'Ohms), on est conduit à utiliser des matériaux magnétorésistifs possédant une forte résistance surfacique (mesurée en Ω.um²). A cette fin, il a été proposé d'introduire dans la couche séparatrice non magnétique une couche d'oxyde discontinue destinée à confiner les lignes de courant. Cette approche conduit cependant à des densités de courant très élevées et, par suite, à des phénomènes d'électromigration préjudiciables à la durée de vie du capteur. Enfin, la technique la plus prometteuse semble être celle fondée sur l'utilisation de jonctions tunnels magnétorésistives ou MTJs (*Magnetic Tunnel Junctions*). Une jonction MTJ se distingue d'une vanne de spin à configuration CPP en ce que la couche séparatrice 130 est en matériau isolant, par exemple de l'alumine ou de la magnésie (MgO).

Une autre limitation des vannes de spin provient du bruit affectant le signal de lecture. Celui-ci est d'origine diverse. Comme indiqué dans l'article de N. Smith et al. intitulé « White-noise magnetization fluctuations in magnetoresistive heads », publié dans Appl. Phys. Lett. 78 (2001), pp. 1148-1150, lorsqu'une vanne de spin présente une faible variation relative de magnétorésistance, c'est-à-dire un faible rapport Δ*R*/*R* où Δ*R* est la variation de résistance entre les états parallèle et antiparallèle, la source prédominante de bruit est d'origine électrique, plus précisément le bruit Johnson résultant du mouvement brownien des électrons de conduction. En revanche, si ce rapport est élevé, la source prédominante de bruit est d'origine magnétique. En effet, dans ce cas, les fluctuations de l'aimantation dans la couche sensible peuvent engendrer des fluctuations importantes de la résistance du capteur. Ces fluctuations de l'aimantation peuvent être induites par l'agitation thermique ou résulter du piégeage de parois ou de l'instabilité de domaines magnétiques. Pour une même puissance dissipée, les fluctuations thermiques seront d'autant plus importantes que la taille du capteur sera faible.

De la même façon, pour un capteur à jonction MTJ à faible rapport Δ*R*/*R*, la source de bruit prédominante est d'origine électrique, à savoir le bruit de grenaille (*shot noise*) de la jonction tunnel, alors qu'à rapport Δ*R*/*R* élevé, le bruit est essentiellement d'origine magnétique comme indiqué précédemment.

Ainsi, pour les capteurs magnétorésistifs à vannes de spin ou à jonctions tunnel magnétiques de très grande sensibilité (c'est-à-dire à rapport Δ*R*/*R* élevé), le rapport signal à bruit (*SNR*) est essentiellement conditionné par le bruit d'origine magnétique.

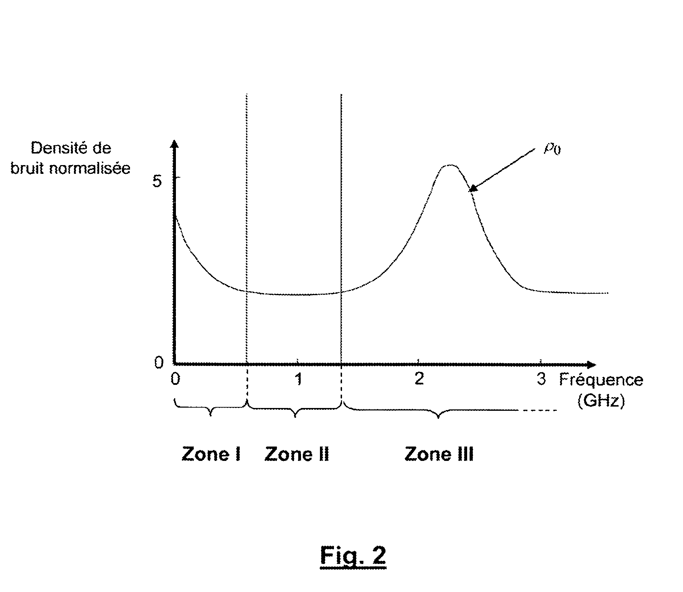

On a représenté en Fig. 2 la courbe typique de densité de bruit (normalisée par *RI*² où *R* est la résistance du capteur et *I* le courant le traversant) affectant le signal de mesure dans un capteur magnétorésistif (à base de vanne de spin CPP ou de jonction tunnel magnétique) en fonction de la fréquence *f* du champ magnétique mesuré.

On distingue trois régimes de bruit distincts :

Dans une zone de basse fréquence, notée zone (I), allant de 0 à quelques centaines de MHz, le bruit de mesure est la somme d'un bruit blanc, partiellement d'origine électrique (bruit Johnson ou bruit de grenaille) et partiellement d'origine magnétique (fluctuations thermiques d'aimantation dans la couche sensible du capteur), et d'un bruit en 1/*f* provenant d'une polarisation magnétique insuffisante de la couche sensible par le champ magnétique de biais. En effet, une polarisation insuffisante peut donner naissance dans la couche sensible à des parois susceptibles de se déplacer de façon irréversible ou encore à des domaines magnétiques instables dont l'aimantation peut sauter lors de la rotation de l'aimantation de la couche sensible.

Dans une zone de haute fréquence, notée zone (III), s'étendant typiquement de 1.5 GHz environ à quelques dizaines de GHz, l'allure de la courbe de bruit est due à un phénomène de résonance ferromagnétique dite FMR (*FerroMagnetic Resonance*). Les excitations FMR activées thermiquement sont naturellement amplifiées lorsque leur fréquence correspond à la fréquence naturelle de précession de l'aimantation de la couche sensible.

Une zone intermédiaire, notée zone (II), sépare les zones de basse et de haute fréquence. Dans cette zone, le bruit est essentiellement blanc, le bruit en 1/*f* et la résonance FMR sont quasi-absents.

Le but de la présente invention est par conséquent de proposer une structure de capteur magnétorésistif de très hautes performances (grande sensibilité, faibles dimensions) tout en ayant un haut niveau de rapport signal à bruit dans une plage de fréquence d'intérêt.

### EXPOSÉ DE L'INVENTION

La présente invention est définie par un capteur magnétorésistif comprenant une première couche magnétique d'aimantation piégée, dite couche piégée, et une couche magnétique d'aimantation libre, dite couche sensible, dont l'aimantation, en absence de champ extérieur, est sensiblement orthogonale à l'aimantation de la couche piégée, lesdites couches piégée et sensible étant séparées par une première couche séparatrice de découplage magnétique.

Selon un premier mode de réalisation, le capteur magnétorésistif comprend en outre une couche, dite de couplage latéral, située du côté de la couche sensible opposé à celui de la couche séparatrice et adaptée à rétrodiffuser, avec conservation de spin, les électrons vers la couche sensible, ainsi que des moyens pour faire circuler un courant continu de la couche de couplage latéral à la couche piégée.

Selon une première variante, la couche séparatrice est une première couche isolante, formant une première barrière tunnel.

Selon une seconde variante, la couche séparatrice est une première couche isolante discontinue adaptée à confiner le courant qui la traverse selon une pluralité de chemins de courant.

Selon une troisième variante, la couche séparatrice est une première couche métallique non magnétique.

Selon la première ou seconde variante, la couche de couplage latéral peut avantageusement comprendre une seconde couche isolante ou semiconductrice formant une seconde barrière tunnel et de résistivité surfacique inférieure à celle de la couche séparatrice.

Alternativement, la couche de couplage latéral peut comprendre une seconde couche isolante discontinue adaptée à confiner le courant qui la traverse et de résistivité surfacique inférieure à celle de la couche séparatrice.

Le capteur magnétorésistif peut en outre comprendre une seconde couche métallique, directement en contact avec la couche sensible, ladite seconde couche métallique incorporant ou étant adjointe à une troisième couche métallique de plus forte résistivité que la seconde couche métallique.

Selon un second mode de réalisation, le capteur magnétorésistif comprend une couche de couplage latéral, située du côté de la couche sensible opposé à celui de la couche séparatrice et adaptée à réduire la diffusion latérale des électrons et/ou à produire une perte de mémoire de spin, ainsi que des moyens pour faire circuler un courant continu de la couche piégée à la couche de couplage latéral.

Selon une première variante, la couche séparatrice est une première couche isolante, formant une première barrière tunnel.

Selon une seconde variante, la couche séparatrice est une première couche isolante discontinue adaptée à confiner le courant qui la traverse selon une pluralité de chemins de courant.

Selon une troisième variante, la couche séparatrice est une première couche métallique non magnétique.

Selon la première ou seconde variante, la couche de couplage latéral peut être de résistivité élevée et telle que le libre parcours moyen des électrons à l'intérieur de cette couche soit inférieur à la dimension latérale caractéristique des zones d'aimantation uniforme de la couche sensible.

Alternativement, selon l'une des trois variantes, la couche de couplage latéral peut être une seconde couche métallique de faible résistivité et comprendre des impuretés adaptées à provoquer un basculement de spin.

La seconde couche métallique peut présenter une résistivité inférieure à celle de la première couche métallique.

La première couche séparatrice peut être en alumine, en MgO, ou en TiOₓ.

La première couche métallique peut être en Cu.

La seconde couche isolante peut être en alumine, en MgO, ou en TiOₓ, ou encore une nanocouche de TaO.

La seconde couche isolante peut être réalisée par oxydation d'un alliage ou d'une bicouche AlCu.

La seconde couche métallique peut être en Cu et la troisième couche métallique appartient au groupe constitué par Ta, Ru, Cr, Zr, Nb, Mo, Hf, W, Re.

La couche de couplage latéral peut être en Ta, Ru ou Cr.

La couche de couplage latéral est en alliage NiFeCr ou NiCoFeCr.

La couche de couplage latéral peut encore être constituée d'une lamination de monocouches atomiques de Ta et Cu.

Les impuretés adaptées à provoquer un basculement peuvent appartenir au groupe constitué par Mn, Pd, Ru, Pt, Hf, Ta, W, Re, Ir, Pt, Au.

Le capteur magnétorésistif selon la première ou la seconde variante peut comprendre en outre une couche ferrimagnétique synthétique, constituée d'une première et d'une seconde sous-couches magnétiques prenant en sandwich une sous-couche de couplage antiferromagnétique, la première sous-couche magnétique étant piégée par une couche antiferromagnétique de piégeage, la seconde sous-couche magnétique constituant ladite couche piégée.

La couche ferrimagnétique synthétique peut être CoFe/Ru/CoFe où les sous-couches magnétiques de CoFe ont une épaisseur entre 1 et 5nm et la première sous-couche de couplage antiferromagnétique de Ru a une épaisseur de 0.5 à 1 nm.

Alternativement, la couche ferrimagnétique synthétique peut être CoFe/Ru/CoFeB ou CoFe/Ru/CoFe où les sous-couches magnétiques de CoFe et CoFeB ont une épaisseur entre 1 et 5nm et la première sous-couche de couplage antiferromagnétique de Ru a une épaisseur de 0.5 à 1 nm et la seconde sous-couche magnétique est en alliage CoFeB ou CoFe à structure cubique centrée.

La couche antiferromagnétique de piégeage peut être en PtMn, PtPdMn, ou IrMn, par exemple PtMn avec une épaisseur de 15 à 25 nm.

La couche sensible peut être en alliage CoFe, en particulier Co₉₀Fe₁₀.

Alternativement, la couche sensible peut être constituée de deux sous-couches, l'une de Co ou d'alliage CoFe, d'une épaisseur de 0.5nm à 2nm, directement à l'interface avec la couche séparatrice, l'autre, de NiFe d'épaisseur de 1.5 à 5nm.

### BRÈVE DESCRIPTION DES DESSINS

D'autres caractéristiques et avantages de l'invention apparaîtront à la lecture d'un mode de réalisation préférentiel de l'invention, fait en référence aux figures jointes parmi lesquelles :
La Fig. 1 illustre schématiquement un capteur magnétorésistif à vanne de spin en configuration CPP, connu de l'état de la technique ;
La Fig. 2 représente la densité de bruit affectant le signal de mesure dans le capteur magnétorésistif de la Fig.1 ;
Les Figs. 3A à 3D illustrent de manière schématique l'effet de transfert de spin latéral dans une couche magnétique ;
La Fig. 4 illustre schématiquement un capteur magnétorésistif selon l'invention ;
Les Figs. 5A et 5B illustrent schématiquement le détail du capteur magnétorésistif selon deux variantes d'un premier mode de réalisation de l'invention.

### EXPOSÉ DÉTAILLÉ DE MODES DE RÉALISATION PARTICULIERS

L'idée à la base de l'invention est d'utiliser l'effet dit de transfert de spin latéral pour réduire le bruit d'origine magnétique dans un capteur magnétorésistif.

L'effet de transfert de spin latéral, aussi appelé « *self-torque* » dans la littérature, a été décrit dans l'article de M.D. Stiles et al. intitulé «Phenomenological theory of current-induced magnetization precession » publié dans Phys. Rev. B. Vol. 69, 054408 (2004) ainsi que dans l'article de M.L. Polianski et al. intitulé « Current-induced transverse spin wave instability in a thin nanomagnet » publié dans Phys. Rev. Lett. Vol. 92, Number 2, 026602 (2004).

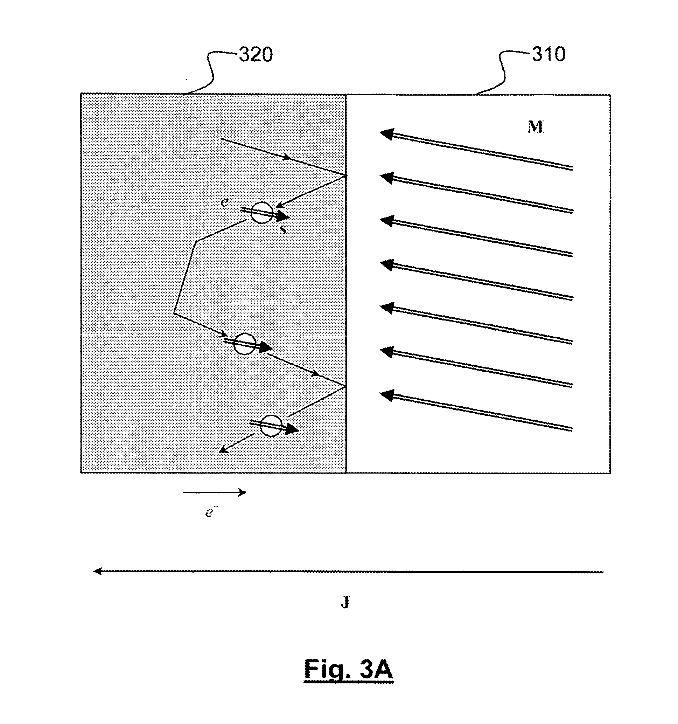

Les Figs. 3A à 3C illustrent de manière schématique le phénomène de transfert de spin latéral.

On a représenté sur ces figures l'interface entre une couche magnétique libre, ou couche sensible 310, et une couche non magnétique métallique 320.

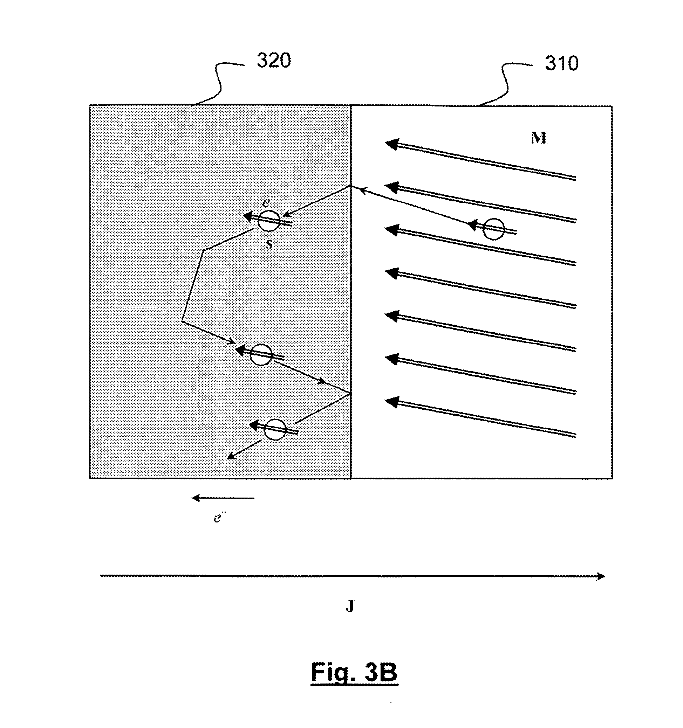

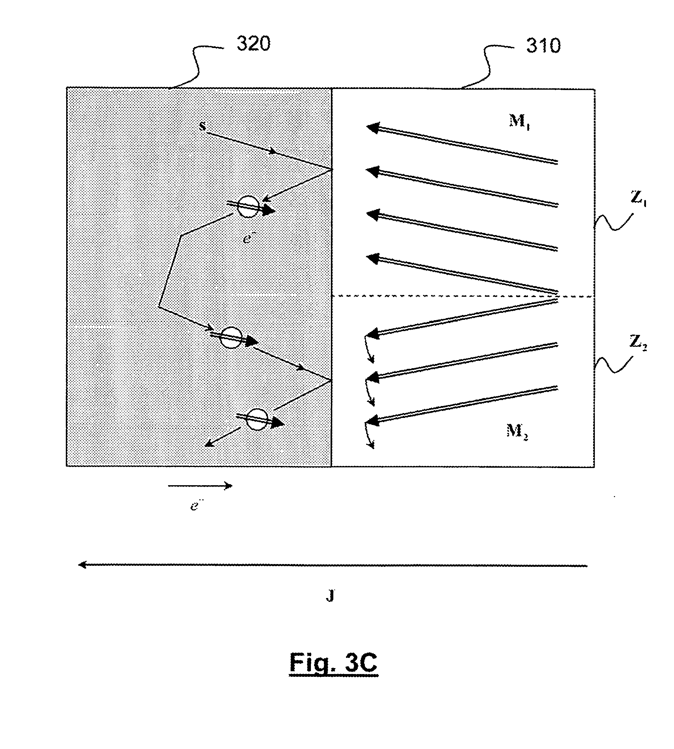

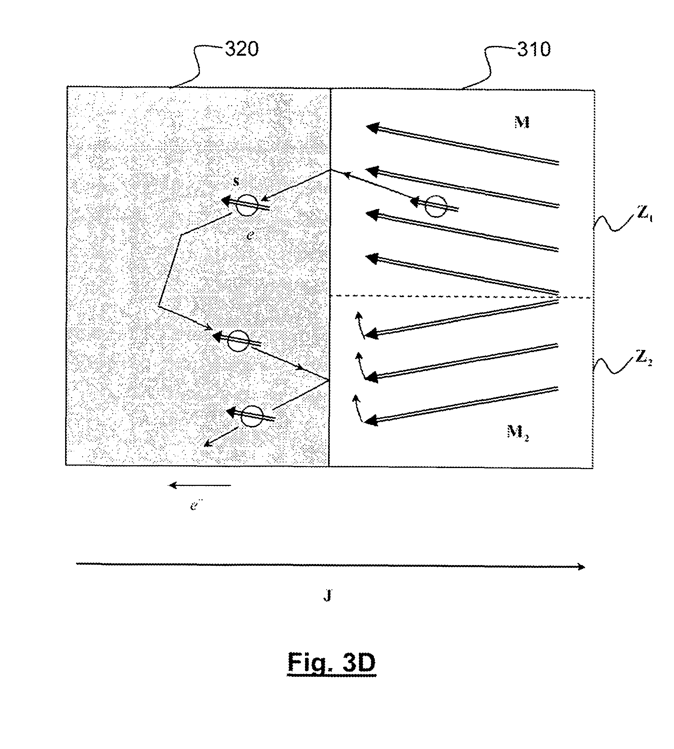

On distingue le cas où l'aimantation **M** à l'intérieur de la couche sensible est supposée parfaitement uniforme en Figs. 3A et 3B et où elle présente des fluctuations en Figs. 3C et 3D.

En Figs. 3A et 3C, un courant spin circule de la couche sensible vers la couche non magnétique, c'est-à-dire que les électrons vont de la couche non magnétique à la couche *sensible. A contrario,* en Figs. 3B et 3D, un courant polarisé en spin circule de la couche non-magnétique vers la couche sensible, c'est-à-dire que les électrons vont de la couche sensible à la couche non magnétique.

Dans la configuration de la Fig. 3A, les électrons provenant de la couche non magnétique et possédant un spin s antiparallèle à l'aimantation **M** sont réfléchis par la couche sensible. Les électrons réfléchis diffusent ensuite latéralement et sont ramenés à nouveau à l'interface par le champ électrique, tout en gardant leur direction en spin. Leur interaction avec l'aimantation de la couche sensible est par conséquent latéralement invariante. L'équilibre de la couche sensible est toutefois instable comme nous le verrons plus loin en Fig. 3C.

Dans la configuration de la Fig. 3B, les électrons provenant de la couche sensible ont leurs spins **s** polarisés selon la direction de l'aimantation **M** et pénètrent dans la couche non magnétique sous l'action du champ électrique. Certains de ces électrons, dans leur mouvement brownien, sont rétrodiffusés vers l'interface mais, étant donné que leurs spins restent parallèles à **M** , leur interaction avec la couche sensible est invariante latéralement.

Dans la configuration de la Fig. 3C, un électron provenant de la couche non magnétique ayant un spin **s** antiparallèle à l'aimantation locale **M₁** d'une première zone **Z₁** de la couche sensible est réfléchi à l'interface, puis diffuse latéralement avant de revenir vers une autre zone **Z₂** de la couche sensible d'aimantation locale **M₂**, d'orientation distincte de celle de **M₁**. Son spin s se réoriente alors de manière antiparallèle à **M₂,** en transférant son moment magnétique à la couche sensible. Ce transfert accentue la désorientation de **M₂** par rapport à **M₁.** L'effet de spin latéral déstabilise la couche sensible par accroissement des fluctuations de son aimantation.

A l'inverse, en Fig. 3D, un électron issu d'une première zone **Z₁** de la couche sensible, polarisé selon l'aimantation locale **M₁** de cette zone, a une probabilité non négligeable, dans son mouvement brownien, d'être rétrodiffusé vers l'interface au sein de la couche non-magnétique. S'il revient vers une zone **Z₂** de la couche sensible d'aimantation locale **M₂**, distincte de **M₁**, son spin **s** s'oriente de manière parallèle à **M₂**, en transférant son moment magnétique à la couche sensible. Ce transfert est équivalent à un couple qui tend à aligner l'aimantation **M₂** dans la direction de **M₁**. Dans ce cas, l'effet transfert de spin latéral stabilise la couche sensible par uniformisation de son aimantation.

L'effet de transfert de spin latéral est un transfert de spin qu'exerce la couche sensible sur elle-même, grâce au couplage latéral exercé par les électrons ayant traversé ou ayant été réfléchis par l'interface.

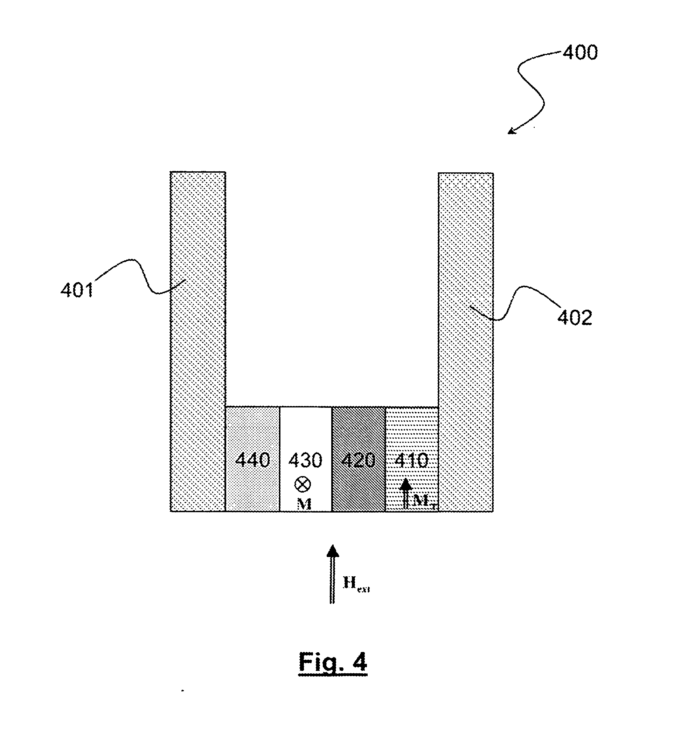

La Fig. 4 illustre la structure d'un capteur selon l'invention.

Le capteur 400 comprend deux écrans métalliques 401 et 402 servant à délimiter la zone de mesure du champ magnétique, à amener un courant continu et à récupérer la tension de mesure.

Il comprend en outre essentiellement, comme dans l'art antérieur, une première couche magnétique 410, dont l'aimantation est piégée par une couche antiferromagnétique (non représentée), et une couche magnétique libre 430, constituant la couche sensible. Une couche séparatrice non magnétique 420 permet le découplage de la couche piégée et de la couche sensible. La couche séparatrice peut être une couche métallique, typiquement en Cu, éventuellement arrangée en sandwich avec une couche d'oxyde discontinue pour confiner les lignes de courant, ou encore une fine couche isolante, par exemple de l'alumine ou de la magnésie (MgO). On obtient respectivement une vanne de spin, une vanne de spin à confinement de courant, ou une jonction tunnel magnétique.

La couche antiferromagnétique peut être constituée en alliage IrMn, PtMn, PtPdMn. La couche piégée est par exemple une couche simple de CoFe 3nm ou bien fait partie d'une structure antiferromagnétique synthétique CoFe/Ru/CoFe comme on le verra plus loin.

La première couche magnétique piégée, 410, possède une aimantation **M_{T}** orientée selon une direction fixe, sensiblement parallèle à la direction du champ magnétique extérieur **Hₑₓₜ** que l'on cherche à mesurer. La couche magnétique libre possède, en absence de champ magnétique extérieur, une aimantation **M** dans le plan de celle-ci, orthogonale à l'aimantation de la première couche. Cette orientation orthogonale peut être obtenue en appliquant un champ magnétique de biais (*bias magnetic field*) au moyen d'un couple d'aimants permanents latéraux, par exemple en alliage CoCr, situés de part et d'autre de l'élément magnétorésistif. Alternativement, dans le cas où cet élément est une jonction tunnel, l'orientation orthogonale de l'aimantation de la couche libre peut être obtenue par une couche d'aimant permanent située dans l'empilement (*in-stack bias*) entre la jonction tunnel et les écrans métalliques servant à l'amenée du courant. L'aimantation de la couche d'aimant permanent est choisie dans le plan des couches et orthogonale à celle de la couche piégée. En se refermant en partie à travers la couche libre de la jonction tunnel, le champ magnétique généré par la couche d'aimant permanent polarise la couche libre dans la direction souhaitée.

Le choix d'une polarisation orthogonale dans la couche sensible permet d'obtenir une réponse linéaire du capteur, la magnétorésistance de la vanne de spin ou de la jonction tunnel variant alors comme le cosinus de l'angle entre les aimantations de la couche sensible et de la couche piégée.

A la différence de l'art antérieur, le capteur 400 comprend en outre une seconde couche 440, dénommée ci-après couche de couplage latéral, destinée à contrôler l'effet de transfert de spin latéral sur la couche sensible.

Selon un premier mode de réalisation, le capteur comprend des moyens (par exemple une source de courant, non représentée) pour faire circuler un courant continu de la couche de couplage latéral à la couche piégée, c'est-à-dire que les électrons vont de la couche sensible à la couche de couplage latéral comme dans la Fig. 3D.

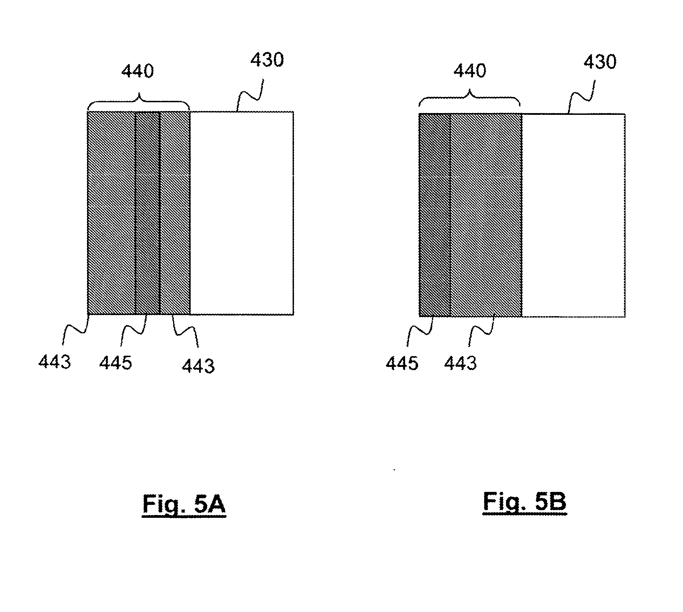

Selon le premier mode de réalisation, la couche de couplage latéral est adaptée à favoriser la rétrodiffusion des électrons vers la couche sensible avec conservation du spin lors de cette rétrodiffusion. De manière générale, la couche de couplage latéral 440 comprend une couche rétrodiffusante 445, éventuellement incorporée ou adjointe à une couche métallique 443, comme illustré respectivement en Figs. 5A et 5B. L'effet de spin latéral stabilise l'aimantation de la couche sensible et le bruit d'origine magnétique dans le capteur est par suite réduit lorsqu'il est utilisé dans la zone (I) de la Fig. 2.

Le choix de la couche de couplage latéral dépend de la nature de la couche séparatrice 420. En effet, la résistance de la couche de couplage latéral est en série avec la magnétorésistance de l'empilement couche piégée/couche séparatrice/couche sensible (vanne de spin ou jonction tunnel). Or, la résistance de la couche de couplage est sensiblement indépendante du champ magnétique mesuré, ce qui réduit la variation relative de résistance Δ*R*/*R* du capteur et donc sa sensibilité. On choisit donc avantageusement une couche de couplage latéral de résistance sensiblement plus faible que celle de l'empilement couche piégée/couche séparatrice/couche sensible.

Par exemple, si la couche séparatrice est une barrière tunnel, la couche rétrodiffusante 445 pourra être selon le cas :
a) une seconde barrière tunnel plus fine et/ou ayant une plus faible hauteur de barrière que la première barrière tunnel, isolante ou semiconductrice ;
b) une couche de confinement de courant, c'est à-dire une couche isolante discontinue assurant le confinement des chemins de courant ;
c) une couche métallique de plus forte résistivité que la couche métallique 443, directement en contact avec la couche sensible.

La résistivité surfacique de la seconde barrière tunnel/couche de confinement de courant sera choisie sensiblement inférieure à celle de la première barrière tunnel.

Si la couche séparatrice est une couche à confinement de courant, la couche rétrodiffusante 445 pourra être selon le cas :
a) une très fine barrière tunnel, isolante ou semiconductrice ;
b) une seconde couche à confinement de courant ;
c) une couche métallique de plus forte résistivité que la couche métallique 443, directement en contact avec la couche sensible.

La résistivité surfacique de la barrière tunnel/ seconde couche de confinement de courant sera choisie sensiblement inférieure à celle de la première couche de confinement de courant.

Enfin, si la couche séparatrice est une couche métallique, la couche rétrodiffusante 445 est de préférence une couche métallique de plus forte résistivité que la couche métallique 443, qui l'incorpore ou qui lui est adjointe, et qui est directement en contact avec la couche sensible.

Pour que les électrons conservent autant que possible leur spin au cours de leur mouvement de rétrodiffusion, il faut éviter d'introduire dans la couche de couplage latéral des éléments tendant à produire un basculement du spin (spin-flip) comme le Pd, Pt, Mn, Au.

Selon un second mode de réalisation de l'invention, le capteur comprend des moyens (par exemple une source de courant non représentée) pour faire circuler un courant continu de la couche piégée à la couche de couplage latéral, c'est-à-dire que les électrons vont de la couche de couplage latéral à la couche sensible comme dans la Fig. 3C.

Selon le second mode de réalisation, la couche de couplage latéral est adaptée à réduire la diffusion latérale des électrons (réfléchis par la couche sensible) et/ou à produire une perte de mémoire de spin des électrons rétrodiffusés. De cette manière, les fluctuations d'aimantation dans la couche sensible ne sont pas amplifiées par l'effet de transfert de spin latéral. Ceci permet de maintenir à un niveau relativement peu élevé le bruit d'origine magnétique dans le capteur magnétorésistif.

Le choix de la couche de couplage latéral dépend là aussi de la nature de la couche séparatrice.

Par exemple, si la couche séparatrice est une barrière tunnel ou une couche à confinement de courant, la couche de couplage latéral pourra comprendre selon le cas :
a) une couche de résistivité électrique élevée, dans laquelle les électrons auront un court libre parcours moyen. Par court libre parcours moyen, on entend un libre parcours moyen inférieur à la dimension latérale caractéristique des zones d'aimantation uniforme de la couche sensible ;
b) une couche métallique de faible résistivité mais contenant des impuretés provoquant un basculement de spin des électrons.

Enfin, si la couche séparatrice est une couche métallique, la couche de couplage latéral pourra comprendre une couche métallique de faible résistivité contenant des impuretés provoquant un basculement de spin.

Le capteur magnétorésistif selon l'invention peut être réalisé de la manière suivante.

On procède tout d'abord, de préférence, au dépôt d'une couche tampon non-magnétique sur une électrode d'amenée de courant, par exemple l'un des écrans métalliques délimitant la zone de mesure. Cette couche tampon a pour but de promouvoir la croissance de la structure et peut être constituée par exemple par NiFeCr 5nm. On réalise ensuite successivement :
(a) une première couche antiferromagnétique de piégeage par exemple en PtMn, PtPdMn, ou IrMn, préférentiellement en PtMn d'épaisseur 15 à 25nm ;
puis, soit l'option (b1) ou l'option (b2) suivante :
(b1) une couche magnétique simple directement en contact avec la couche antiferromagnétique, par exemple une couche en alliage CoFe, riche en Co, d'épaisseur typique de l'ordre de 3nm. Cette couche simple constitue alors la couche magnétique piégée du capteur selon l'invention ; ou bien
(b2) une couche composite ferrimagnétique artificielle constituée par :
   - une première sous-couche piégée en contact avec la couche antiferromagnétique, par exemple une couche en alliage CoFe riche en Co d'épaisseur typique de l'ordre de 3nm ;
   - une couche de couplage antiferromagnétique de Ru d'épaisseur typique entre 0.5 et 1nm ;
   - une seconde sous-couche piégée qui constitue en fait la couche magnétique piégée 410 du capteur 400. Cette seconde sous-couche piégée peut être en CoFe, riche en Co. Elle peut aussi être en CoFeB ou en CoFe, de structure cubique centrée, si la couche séparatrice est isolante, en MgO ;
(c) une couche non magnétique constituant la couche séparatrice du capteur selon l'invention. Elle peut être isolante, par exemple en alumine ou en MgO ou en TiOₓ, pour réaliser une barrière tunnel. Elle peut être aussi métallique, par exemple en Cu, pour réaliser une vanne de spin. Elle peut être enfin une couche composite d'isolant et de métal, par exemple produite par oxydation d'une fine couche d'alliages Al₁₋ₓCuₓ avec x entre 0.005 et 0.05 volumique, pour réaliser une structure à confinement de courant ;
(d) une couche en alliage CoFe, riche en Co, en particulier Co₉₀Fe₁₀, constituant la couche sensible du capteur selon l'invention. Cette couche peut être alternativement formée par l'association de deux sous-couches Co et Fe, d'épaisseur totale 1nm, directement en contact avec la première couche séparatrice puis une couche NiFe 3nm pour augmenter la douceur magnétique de la couche précédente.
   Cependant, si la première couche séparatrice sous-jacente est en MgO avec une structure cubique centrée, on préférera utiliser un alliage CoFe présentant la même structure ou un alliage CoFeB amorphe que l'on recuira ensuite. On réduit ainsi les défauts d'appariement de réseau à l'interface ;
(e) une couche de couplage latéral dont on distinguera la composition selon le mode de réalisation de l'invention.

Dans le cas du premier mode de réalisation, la composition de la couche de couplage dépend, comme on a vu précédemment, de la nature de la couche séparatrice.

Si la couche séparatrice forme une barrière tunnel, la couche de couplage latéral peut comprendre, selon le cas :
e₁) une seconde barrière tunnel très fine, par exemple une couche isolante de même matériau que la première barrière tunnel, mais de plus faible épaisseur, par exemple entre 0.3 et 0.6 nm ;
e₂) une couche isolante discontinue, permettant le confinement de chemins de courant, par exemple une couche de TiOx, ou une nanocouche d'oxyde non magnétique, par exemple TaO. Cette couche isolante discontinue peut être aussi réalisée par oxydation d'un alliage ou d'une bicouche AlCu comprenant quelques % de Cu ;
e₃) une bicouche métallique comprenant une première sous-couche d'un métal de faible résistivité directement en contact avec la couche sensible, et une seconde sous-couche d'un métal de plus forte résistivité que celui de la première sous-couche, ou dont l'interface avec la première sous-couche présente une forte résistivité ou une marche de potentiel pour les électrons, par exemple une première sous-couche en Cu et une seconde sous-couche en Ta,Ru,Cr,Zr,Nb,Mo,Hf,W ou Re.

Si la couche séparatrice est une couche à confinement de courant, la couche de couplage latéral peut être également selon l'une des options (e₁), (e₂) ou (e₃) précédentes. Pour les options (e₁) et (e₂), la barrière tunnel/ seconde couche de confinement doit être de plus faible résistivité que celle de la première couche à confinement de courant.

Si la couche séparatrice est une couche métallique, la couche de couplage latéral comprendra de préférence une première sous-couche métallique de faible résistivité directement en contact avec la couche sensible, ainsi qu'une seconde sous-couche métallique de plus forte résistivité que la première ou dont l'interface avec la première sous-couche présente une forte résistance ou une marche de potentiel pour les électrons. Par exemple, la première sous-couche sera en Cu et la seconde sous-couche en Ta, Ru, Cr, Zr, Nb, Mo, Hf, W ou Re.

Dans le cas du second mode de réalisation, la composition de la couche de couplage dépend, comme on l'a vu précédemment, de la nature de la couche séparatrice.

Si la couche séparatrice est une barrière tunnel ou une couche à confinement de courant, la couche de couplage latéral pourra comprendre, l'une ou l'autre des deux options ci-dessous (e4 et e5) :
e₄) une couche de résistivité électrique élevée et de 0.2nm à quelques nm d'épaisseur. Cette couche peut être par exemple en Ta, Ru, Cr ou en des alliages NiFeCr ou NiCoFeCr, conférant aux électrons un court libre parcours moyen. Cette couche peut également être constituée d'une lamination de monocouches atomiques de Ta et Cu ;
e₅) une couche métallique de faible résistivité mais contenant des impuretés provoquant un basculement de spin des électrons. On pourra utiliser comme impuretés des ions magnétiques tels que Mn, et/ou des éléments présentant un fort couplage spin-orbite, tels que Pd, Ru, Pt, Hf, Ta, W, Re, Ir, Au.

Ces deux options peuvent aussi être combinées par l'adjonction dans une couche de forte résistivité telle que décrite dans l'option (e₄), d'impuretés provoquant un basculement du spin des électrons comme indiqués dans l'option (e₅).

Enfin, si la couche séparatrice est métallique, la couche de couplage latéral sera alors réalisée comme dans l'option (e₅) ci-dessus.

## Revendications

1. Capteur magnétorésistif comprenant une première couche magnétique d'aimantation piégée (410), dite couche piégée, et une couche magnétique d'aimantation libre (430), dite couche sensible, dont l'aimantation, en absence de champ extérieur, est sensiblement orthogonale à l'aimantation de la couche piégée, lesdites couches piégée et sensible étant séparées par une première couche séparatrice (420) de découplage magnétique, **caractérisé en ce qu'**il comprend en outre une couche (440), dite de couplage latéral, située du côté de la couche sensible opposé à celui de la couche séparatrice et adaptée à rétrodiffuser, avec conservation de spin, les électrons vers la couche sensible, ainsi que des moyens pour faire circuler un courant continu de la couche de couplage latéral à la couche piégée.

2. Capteur magnétorésistif selon la revendication 1, **caractérisé en ce que** la couche séparatrice est une première couche isolante, formant une première barrière tunnel.

3. Capteur magnétorésistif selon la revendication 1, **caractérisé en ce que** la couche séparatrice est une première couche isolante discontinue adaptée à confiner le courant qui la traverse selon une pluralité de chemins de courant.

4. Capteur magnétorésistif selon la revendication 1, **caractérisé en ce que** la couche séparatrice est une première couche métallique non magnétique.

5. Capteur magnétorésistif selon la revendication 2 ou 3, **caractérisé en ce que** la couche de couplage latéral comprend une seconde couche isolante ou semiconductrice formant une seconde barrière tunnel et de résistivité surfacique inférieure à celle de la couche séparatrice.

6. Capteur magnétorésistif selon la revendication 2 ou 3, **caractérisé en ce que** la couche de couplage latéral comprend une seconde couche isolante discontinue adaptée à confiner le courant qui la traverse et de résistivité surfacique inférieure à celle de la couche séparatrice.

7. Capteur magnétorésistif selon la revendication 2,3 ou 4, **caractérisé en ce qu'**elle comprend une seconde couche métallique (443), directement en contact avec la couche sensible, ladite seconde couche métallique incorporant ou étant adjointe à une troisième couche métallique (445) de plus forte résistivité que la seconde couche métallique.

8. Capteur magnétorésistif comprenant une première couche magnétique d'aimantation piégée (410), dite couche piégée, et une couche magnétique d'aimantation libre (430), dite couche sensible, dont l'aimantation, en absence de champ extérieur, est sensiblement orthogonale à l'aimantation de la couche piégée, lesdites couches piégée et sensible étant séparées par une première couche séparatrice (420) de découplage magnétique, **caractérisé en ce qu'**il comprend en outre une couche (440), dite de couplage latéral, située du côté de la couche sensible opposé à celui de la couche séparatrice et adaptée à réduire la diffusion latérale des électrons , ainsi que des moyens pour faire circuler un courant continu de la couche piégée à la couche de couplage latéral.

9. Capteur magnétorésistif selon la revendication 8, **caractérisé en ce que** la couche séparatrice est une première couche isolante, formant une première barrière tunnel.

10. Capteur magnétorésistif selon la revendication 8, **caractérisé en ce que** la couche séparatrice est une première couche isolante discontinue adaptée à confiner le courant qui la traverse selon une pluralité de chemins de courant.

11. Capteur magnétorésistif selon la revendication 8, **caractérisé en ce que** la couche séparatrice est une première couche métallique non magnétique.

12. Capteur magnétorésistif selon la revendication 9 ou 10, **caractérisé en ce que** la couche de couplage latéral est de résistivité élevée, telle que le libre parcours moyen des électrons à l'intérieur de cette couche soit inférieur à la dimension latérale caractéristique des zones d'aimantation uniforme de la couche sensible.

13. Capteur magnétorésistif selon la revendication 9, 10 ou 11 **caractérisé en ce que** la couche de couplage latéral est une seconde couche métallique de faible résistivité et comprend des impuretés adaptées à provoquer un basculement de spin.

14. Capteur magnétorésistif selon les revendications 11 et 13, **caractérisée en ce que** la seconde couche métallique présente une résistivité inférieure à celle de la première couche métallique.

15. Capteur magnétorésistif selon l'une des revendications précédentes, **caractérisé en ce qu'**il comprend en outre une couche ferrimagnétique synthétique, constituée d'une première et d'une seconde sous-couches magnétiques prenant en sandwich une sous-couche de couplage antiferromagnétique, la première sous-couche magnétique étant piégée par une couche antiferromagnétique de piégeage, la seconde sous-couche magnétique constituant ladite couche piégée (410).

## Claims

1. A magnetoresistive sensor comprising a first pinned-magnetization magnetic layer (410), called pinned layer, and a free-magnetization magnetic layer (430), called sensitive layer, of which the magnetization, in the absence of an external field, is substantially orthogonal to the magnetization of the pinned layer, said pinned and sensitive layers being separated by a first separating layer (420) for magnetic uncoupling, wherein it further comprises a layer (440), called lateral coupling layer, located on the side of the sensitive layer opposite that of the separating layer and suitable for backscattering the electrons, with conservation of spin, to the sensitive layer, and also means for circulating a continuous current from the lateral coupling layer to the pinned layer.

2. The magnetoresistive sensor as claimed in claim 1, wherein the separating layer is a first insulating layer, forming a first tunnel barrier.

3. The magnetoresistive sensor as claimed in claim 1, wherein the separating layer is a first discontinuous insulating layer suitable for confining the current passing through it along a plurality of current paths.

4. The magnetoresistive sensor as claimed in claim 1, wherein the separating layer is a first nonmagnetic metal layer.

5. The magnetoresistive sensor as claimed in either of claims 2 and 3, wherein the lateral coupling layer comprises a second insulating or semiconducting layer forming a second tunnel barrier and having a surface resistivity lower than that of the separating layer.

6. The magnetoresistive sensor as claimed in either of claims 2 and 3, wherein the lateral coupling layer comprises a second discontinuous insulating layer suitable for confining the current passing through it and having a surface resistivity lower than that of the separating layer.

7. The magnetoresistive sensor as claimed in claim 2, 3 or 4, wherein it comprises a second metal layer (443), directly in contact with the sensitive layer, said second metal layer incorporating or being joined to a third metal layer (445) having a higher resistivity than the second metal layer.

8. A magnetoresistive sensor comprising a first pinned-magnetization magnetic layer (410), called pinned layer, and a free-magnetization magnetic layer (430), called sensitive layer, of which the magnetization, in the absence of an external field, is substantially orthogonal to the magnetization of the pinned layer, said pinned and sensitive layers being separated by a first separating layer (420) for magnetic uncoupling, wherein it further comprises a layer (440), called lateral coupling layer, located on the side of the sensitive layer opposite that of the separating layer and suitable for reducing the sidescattering of the electrons, and also means for circulating a continuous current from the pinned layer to the lateral coupling layer.

9. The magnetoresistive sensor as claimed in claim 8, wherein the separating layer is a first insulating layer, forming a first tunnel barrier.

10. The magnetoresistive sensor as claimed in claim 8, wherein the separating layer is a first discontinuous insulating layer suitable for confining the current passing through it along a plurality of current paths.

11. The magnetoresistive sensor as claimed in claim 8, wherein the separating layer is a first nonmagnetic metal layer.

12. The magnetoresistive sensor as claimed in either of claims 9 and 10, wherein the lateral coupling layer has a high resistivity, such that the mean free path of the electrons in said layer is shorter than the characteristic lateral dimension of the uniform magnetization zones of the sensitive layer.

13. The magnetoresistive sensor as claimed in claim 9, 10 or 11, wherein the lateral coupling layer is a second metal layer having a low resistivity and comprises impurities suitable for causing a spin flip.

14. The magnetoresistive sensor as claimed in claims 11 and 13, wherein the second metal layer has a lower resistivity than that of the first metal layer.

15. The magnetoresistive sensor as claimed in one of the preceding claims, wherein it further comprises a synthetic ferrimagnetic layer, consisting of first and second magnetic sub-layers containing an antiferromagnetic coupling sub-layer in a sandwich, the first magnetic sub-layer being pinned by a pinning antiferromagnetic layer, the second magnetic sub-layer constituting said pinned layer (410).

## Patentansprüche

1. Magnetoresistiver Sensor, umfassend eine erste magnetische Schicht mit gefangener Magnetisierung (410), gefangene Schicht genannt, und eine magnetische Schicht mit freier Magnetisierung (430), sensible Schicht genannt, deren Magnetisierung ohne das Vorhandensein ein äußeres Feld im Wesentlichen rechtwinklig zur Magnetisierung der gefangenen Schicht ist, wobei die gefangene und die sensible Schicht getrennt sind durch eine erste Trennschicht (420) zur magnetischen Entkopplung,
**dadurch gekennzeichnet, dass** er außerdem eine so genannte Lateralkopplungsschicht (440) umfasst, die sich auf der zur Trennschicht entgegengesetzten Seite der sensiblen Schicht befindet und angepasst ist, um die Elektronen unter Erhaltung des Spins rückzustreuen in Richtung sensible Schicht, sowie Einrichtungen umfasst, um einen Gleichstrom von der Lateralkopplungsschicht zur gefangenen Schicht fließen zu lassen.

2. Magnetoresistiver Sensor nach Anspruch 1, **dadurch gekennzeichnet, dass** die Trennschicht eine erste Isolierschicht ist, die eine erste Tunnelbarriere bildet.

3. Magnetoresistiver Sensor nach Anspruch 1, **dadurch gekennzeichnet, dass** die Trennschicht eine erste diskontinuierliche Isolierschicht ist, angepasst, um den sie durchquerenden Strom gemäß einer Vielzahl von Stromwegen abgrenzt.

4. Magnetoresistiver Sensor nach Anspruch 1, **dadurch gekennzeichnet, dass** die Trennschicht eine erste nichtmagnetische metallische Schicht ist.

5. Magnetoresistiver Sensor nach Anspruch 2 oder 3, **dadurch gekennzeichnet, dass** die Lateralkopplungsschicht eine zweite Isolier- oder Halbleiterschicht umfasst, die eine zweite Tunnelbarriere bildet und deren flächenbezogene Resistivität kleiner als diejenige der Trennschicht ist.

6. Magnetoresistiver Sensor nach Anspruch 2 oder 3, **dadurch gekennzeichnet, dass** die Lateralkopplungsschicht eine zweite diskontinuierliche Isolierschicht umfasst, angepasst, um den sie durchquerenden Strom abzugrenzen und deren flächenbezogene Resistivität kleiner als diejenige der Trennschicht ist.

7. Magnetoresistiver Sensor nach Anspruch 2, 3 oder 4, **dadurch gekennzeichnet, dass** er eine zweite metallische Schicht (443) mit direktem Kontakt zur sensiblen Schicht umfasst, wobei eine dritte metallische Schicht (445) von höherer Resistivität als die zweite metallische Schicht in die zweite metallische Schicht eingefügt oder ihr angefügt ist.

8. Magnetoresistiver Sensor, umfassend eine erste magnetische Schicht mit gefangener Magnetisierung (410), gefangene Schicht genannt, und eine magnetische Schicht mit freier Magnetisierung (430), sensible Schicht genannt, deren Magnetisierung ohne ein äußeres Feld im Wesentlichen rechtwinklig zur Magnetisierung der gefangenen Schicht ist, wobei die gefangene und die sensible Schicht getrennt sind durch eine erste Trennschicht (420) zur magnetischen Entkopplung,
**dadurch gekennzeichnet, dass** er außerdem eine so genannte Lateralkopplungsschicht (440) umfasst, die sich auf der zur Trennschicht entgegengesetzten Seite der sensiblen Schicht befindet und angepasst ist, um die laterale Streuung der Elektronen zu reduzieren, sowie Einrichtungen umfasst, um einen Gleichstrom von der gefangenen Schicht zur Lateralkopplungsschicht fließen zu lassen.

9. Magnetoresistiver Sensor nach Anspruch 8, **dadurch gekennzeichnet, dass** die Trennschicht eine erste Isolierschicht ist, gebildet durch eine erste Tunnelbarriere.

10. Magnetoresistiver Sensor nach Anspruch 8, **dadurch gekennzeichnet, dass** die Trennschicht eine erste diskontinuierliche Isolierschicht ist, angepasst, um den sie durchquerenden Strom gemäß einer Vielzahl von Stromwegen abzugrenzen.

11. Magnetoresistiver Sensor nach Anspruch 8, **dadurch gekennzeichnet, dass** die Trennschicht eine erste nichtmagnetische metallische Schicht ist.

12. Magnetoresistiver Sensor nach Anspruch 9 oder 10, **dadurch gekennzeichnet, dass** die Lateralkopplungsschicht von hoher Resistivität ist, so dass die mittlere freie Strecke der Elektronen im Innern dieser Schicht kleiner ist als die charakteristische laterale Dimension der Zonen mit einer gleichmäßigen bzw. gleichförmigen Magnetisierung der sensiblen Schicht.

13. Magnetoresistiver Sensor nach Anspruch 9, 10 oder 11, **dadurch gekennzeichnet, dass** die Lateralkopplungsschicht eine zweite diskontinuierliche Isolierschicht von schwacher Resistivität ist und Verunreinigungen umfasst, angepasst, um ein Kippen des Spins zu bewirken.

14. Magnetoresistiver Sensor nach den Ansprüchen 11 und 13, **dadurch gekennzeichnet, dass** die zweite metallische Schicht eine niedrigere Resistivität als die erste metallische Schicht aufweist.

15. Magnetoresistiver Sensor nach einem der vorhergehenden Ansprüche, **dadurch gekennzeichnet, dass** er außerdem eine synthetische ferromagnetische Schicht umfasst, gebildet durch eine erste und eine zweite magnetische Teilschicht, die sandwichförmig eine anitferromagnetische Kopplungsschicht einschließen, wobei die erste magnetische Teilschicht gefangen ist durch eine antiferromagnetische Fangschicht, und die zweite magnetische Teilschicht die genannte gefangene Schicht (410) bildet.
